(19) Europäisches Patentamt
European Patent Office
Office européen des brevets

(11) **EP 4 510 114 A1**

(12) **EUROPEAN PATENT APPLICATION**
published in accordance with Art. 153(4) EPC

(43) Date of publication:
**19.02.2025 Bulletin 2025/08**

(21) Application number: 23788226.1

(22) Date of filing: **05.04.2023**

(51) International Patent Classification (IPC):
*G09F 9/30* (2006.01)        *G02B 3/00* (2006.01)
*G02B 5/20* (2006.01)        *H05B 33/02* (2006.01)
*H10K 50/00* (2023.01)        *H10K 59/00* (2023.01)

(52) Cooperative Patent Classification (CPC):
G02B 3/00; G02B 5/20; G09F 9/30; H05B 33/02;
H10K 50/00; H10K 50/10; H10K 59/00; H10K 59/10

(86) International application number:
**PCT/JP2023/014028**

(87) International publication number:
**WO 2023/199807 (19.10.2023 Gazette 2023/42)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **11.04.2022 JP 2022065160**

(71) Applicant: **Toppan Holdings Inc.
Tokyo 110-0016 (JP)**

(72) Inventor: **NAGATOME Hiroki
Tokyo 110-0016 (JP)**

(74) Representative: **Hoffmann Eitle
Patent- und Rechtsanwälte PartmbB
Arabellastraße 30
81925 München (DE)**

(54) **DISPLAY DEVICE**

(57)     A display unit (1) includes: a device substrate (10) on which a plurality of light sources (11) are disposed; a protective layer (20) provided on the device substrate (10) to cover the plurality of light sources (11); a color filter (30) provided on the protective layer (20), the color filter including a plurality of monochromatic filters (30R, 30G, 30B) disposed corresponding to the plurality of light sources (11); a lens array (40) provided on the color filter (30), the lens array including a plurality of microlenses (41) disposed corresponding to the plurality of monochromatic filters (30R, 30G, 30B); and a flattening layer (50) provided on the lens array (40) to cover the plurality of microlenses (41), the flattening layer having a refractive index lower than a refractive index of the plurality of microlenses (41). A refractive index $n_m$ of the plurality of microlenses (41), a refractive index nt of the flattening layer (50), and a ratio r/H between a curvature radius r and a height H of a lens surface of the plurality of microlenses (41) satisfy a predetermined expression.

FIG.1

**Description**

[Technical Field]

The present invention relates to a display unit.
This application claims priority based on Japanese Patent Application No. 2022-065160 filed April 11, 2022, the contents of which are incorporated herein by reference.

[Background Art]

For high brightness and low power consumption, a so-called micro display including, as a light source, a micro LED, an organic EL device, or the like is required to be improved in usage efficiency of emitted light to enhance efficiency.
In this regard, PTL 1 describes that a semispherical microlens is disposed on a light-emitting device to enhance light-usage efficiency.
Moreover, PTL 2 describes that a translucent layer is provided on a microlens to improve viewing angle characteristics.

[Citation List]

[Patent Literature]

    PTL 1: JP 2021-136208 A
    PTL 2: JP 2020-184481 A

[Summary of the Invention]

[Technical Problem]

A micro LED or an organic EL device is not so high in directionality of outputted light as a light source, so that light enters a microlens at various angles. Light entering at an angle equal to or greater than an optimal angle relative to an interface between a translucent layer and the microlens is fully reflected and thus cannot be externally extracted as an effective outputted light component, which causes a decrease in brightness.
The inventor has conducted a variety of studies about a relationship between a form of a microlens and a translucent layer and completed the present invention on the basis of the obtained findings.
An object of the present invention is to provide a display unit enabling a reduction in loss of outputted light of a micro LED or an organic EL device to improve usage efficiency.

[Solution to Problem]

A first aspect of the present invention is a display unit including: a device substrate on which a plurality of light sources are disposed; a protective layer provided on the device substrate to cover the plurality of light sources; a color filter provided on the protective layer, the color filter including a plurality of monochromatic filters disposed corresponding to the plurality of light sources; a lens array provided on the color filter, the lens array including a plurality of microlenses disposed corresponding to the plurality of monochromatic filters; and a flattening layer provided on the lens array to cover the plurality of microlenses, the flattening layer having a refractive index lower than a refractive index of the plurality of microlenses.
In the display unit, a refractive index $n_m$ of the plurality of microlenses, a refractive index nt of the flattening layer, and a ratio r/H between a curvature radius r and a height H of a lens surface of the plurality of microlenses satisfy the following expression (1):

$$0.3 < (n_m - n_t) - 0.1(r/H)^2 + 0.2(r/H) < 0.6 \dots (1).$$

[Advantageous Effects of the Invention]

The present invention makes it possible to provide a display unit enabling a reduction in loss of outputted light of a micro LED or an organic EL device to improve usage efficiency.

[Brief Description of the Drawings]

[Fig. 1] Fig. 1 is a schematic cross-sectional view illustrating a part of a display unit according to an embodiment of the present invention.

[Fig. 2] Fig. 2 is a diagram illustrating a positional relationship between an organic EL device, a color filter, and a microlens in plan view of the display unit.

[Fig. 3] Fig. 3 is a diagram illustrating a result of ray-trace simulation for a shape of microlenses.

[Fig. 4] Fig. 4 is a diagram illustrating a result of ray-trace simulation for another shape of microlenses.

[Fig. 5] Fig. 5 is a diagram illustrating a result of ray-trace simulation for another shape of microlenses.

[Fig. 6] Fig. 6 is a schematic cross-sectional view illustrating a part of a display unit according to a modification example of an embodiment of the present invention.

[Description of Embodiments]

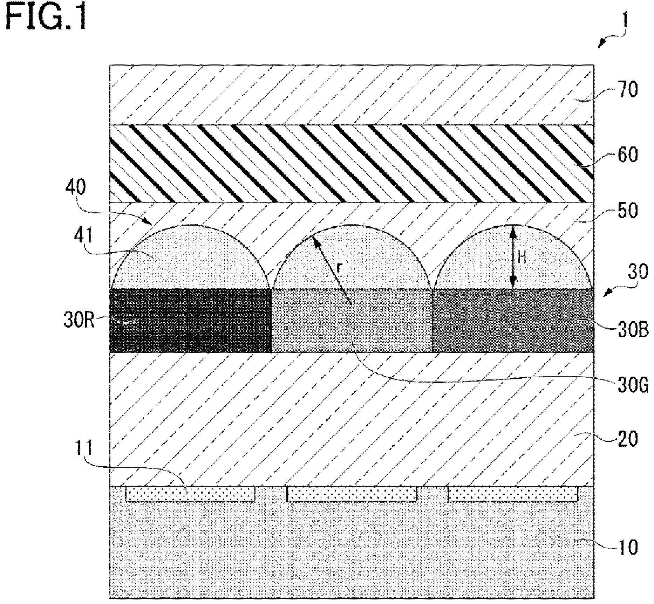

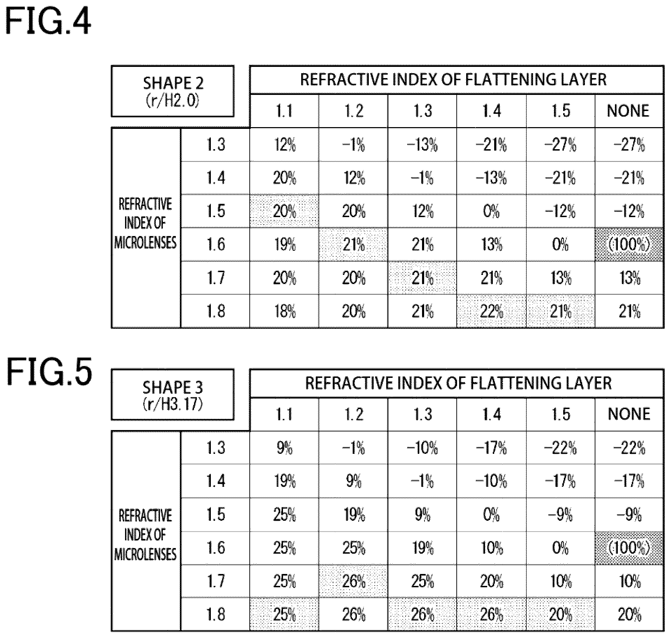

Description will be given below of an embodiment of the present invention with reference to Fig. 1 to Fig. 5. A display unit 1 according to the present embodiment includes organic EL devices 11 as light sources and has a configuration in which a large number of pixels are arranged in front view.

Fig. 1 illustrates a schematic cross-sectional view of a part of the display unit 1 corresponding to one pixel. The display unit 1 includes a device substrate 10 on which the organic EL devices (light sources) 11 are disposed and a protective layer 20, a color filter 30, a lens array 40, and a flattening layer 50, which are formed on the device substrate 10.

A translucent substrate 70 is bonded to the flattening layer 50 via an adhesive layer 60, and a user can see an image displayed by the display unit 1 through the translucent substrate 70.

The organic EL devices 11, which have a known configuration including a pixel electrode, a common electrode, and a functional layer, are connected to non-illustrated wiring provided on the device substrate 10 and to be each independently driven for emission.

The protective layer 20, which is transparent, protects the organic EL devices 11 and achieves flattening to facilitate the installation of the color filter 30. The protective layer 20 may be formed of multiple layers and have gas-barrier properties.

A partition may be formed in the protective layer 20 to define a sub-pixel. The formation of the partition makes it possible to reduce stray light entering adjacent sub-pixels.

The color filter 30 is provided on the respective organic EL devices 11. The color filter 30 includes a plurality of monochromatic filters 30R, 30G and 30B that transmit light in a wavelength band of one of three primary colors of light, red (R), green (G) and blue (B), respectively. The number of the monochromatic filters and the colors of light passing therethrough may be determined in accordance with the display performance or the like of the display unit and yellow or the like may be included. The plurality of monochromatic filters 30R, 30G and 30B are disposed to overlap with the plurality of organic EL devices 11 in plan view. This is occasionally referred to as the plurality of monochromatic filters 30R, 30G and 30B being disposed corresponding to the plurality of respective organic EL devices 11.

The lens array 40 is formed on the color filter 30 and includes a plurality of microlenses 41 arrayed corresponding to the respective monochromatic filters 30R, 30G and 30B of the color filter 30. Here, the plurality of microlenses 41 being arrayed corresponding to the respective monochromatic filters 30R, 30G and 30B of the color filter 30 means the plurality of microlenses 41 being arrayed to overlap with the respective monochromatic filters 30R, 30G and 30B of the color filter 30 in plan view.

The microlenses 41 according to the present embodiment, which are so-called plano-convex lenses, have refractive indexes higher than at least refractive indexes of air and the flattening layer 50. Here, the plurality of microlenses 41 may be considered to each have the same refractive index.

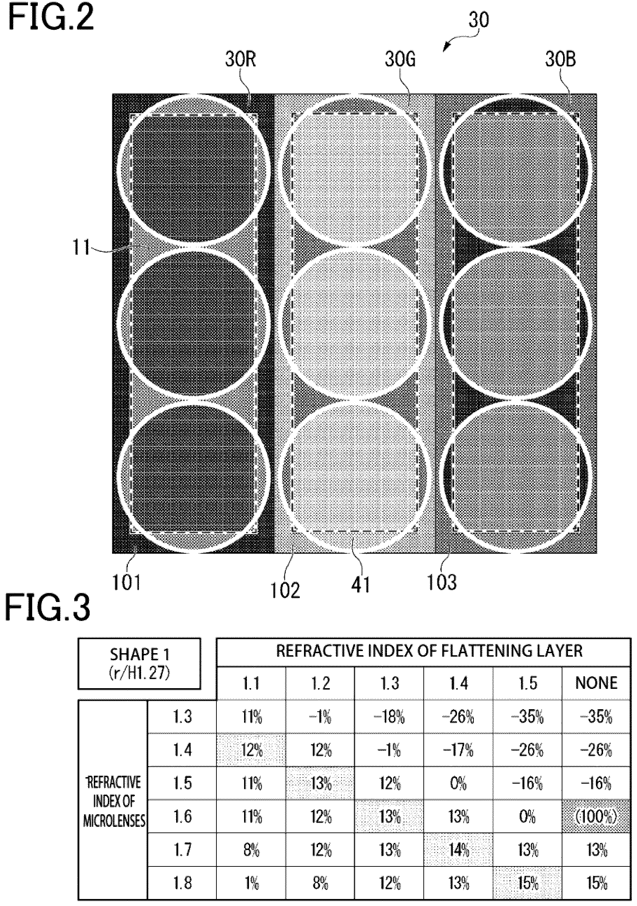

Fig. 2 illustrates a positional relationship between the organic EL devices 11, the color filter 30, and the microlenses 41 in plan view of a range illustrated in Fig. 1.

A pixel of the display unit 1 includes three sub-pixels 101, 102 and 103 corresponding to red (R), green (G) and blue (B), respectively. The red monochromatic filter 30R, the green monochromatic filter 30G, and the blue monochromatic filter 30B, which form the color filter 30, are disposed for the sub-pixels 101, 102 and 103, respectively. One of the organic EL devices 11 and three of the microlenses 41 are disposed for each of the sub-pixels 101, 102 and 103.

The above is merely by way of example and a shape of the sub-pixels in plan view and the numbers of organic EL devices 11 and the microlenses 41 disposed, and the like may be determined in accordance with the display performance or the like.

The flattening layer 50 absorbs unevenness of the microlenses 41 to achieve flattening, which facilitates bonding of the translucent substrate 70. Accordingly, a maximum thickness of the flattening layer 50 is equal to or greater than a height of the microlenses 41.

The flattening layer 50 has a refractive index lower than the refractive index of the microlenses 41. The closer the refractive index of the flattening layer 50 is to the refractive index of air, the greater the difference in refractive index between the flattening layer 50 and the microlenses 41.

The flattening layer 50 contains, by way of example, a hollow filler and a medium. The hollow filler and the medium are transparent at visible wavelengths and have, for example, a 90% or more total light transmissivity to light at visible wavelengths. The hollow filler contributes to reducing the refractive index of the flattening layer 50. The medium intervenes between particles of the hollow filler to couple the hollow filler particles, which stabilizes the flattening layer 50.

A suitable material of the hollow filler can be exemplified by silicon dioxide (silica, $SiO_2$). A hollow filler including silica is inexpensive and has high transparency to visible wavelengths and physical stability. By virtue of the hollow filler contained in a low-refractive-index layer, air regions are scattered in the flattening layer 50, resulting in a decrease in the refractive index of the flattening layer 50, and the refractive index approaches a value of that of air with an increase in the content of the hollow filler.

In the display unit 1, light emitted from the driven organic EL devices 11 enters the microlenses 41 through the protective layer 20 and the color filter 30, and is extracted outside through the flattening layer 50, the adhesive layer 60, and the translucent substrate 70.

During the above-described process, light is also refracted at an interface between upper surfaces (lens surfaces) of the microlenses 41 and the flattening layer 50. Since the refraction varies with a shape of the lens surfaces and the refractive indexes of the microlenses 41 and the flattening layer 50, the inventor conducted a study regarding optimization thereof to efficiently extract light using a ray-trace simulation.

A model used for the simulation is as follows.

(Fixed Parameters)

The shape of the microlenses 41: semispherical
Pitch PD between pixels (gaps): 2.8 μm
The thickness of the flattening layer 50: 1.2 μm
Distance DH between the organic EL device 11 and the microlenses 41: 2.6 μm

(Variable Parameters)

The shape of the microlenses 41

Shape 1
Height H: 1.1 μm, curvature radius r of the lens surface: 1.4 μm (r/H 1.27)
Shape 2
Height H: 0.8 μm, curvature radius r of the lens surface: 1.6 μm (r/H 2.0)
Shape 3
Height H: 0.6 μm, curvature radius r of the lens surface: 1.9 μm (r/H 3.17)
Refractive index of microlenses 41: in increments of 0.1 from 1.3 to 1.8, refractive index of the flattening layer 50: in increments of 0.1 from 1.1 to 1.5, and no flattening layer 50 (the adhesive layer 60 (refractive index 1.7) was disposed on the lens array 40)
Under the above-described conditions, the refractive index of the microlenses 41 was changed in increments of 0.1 and a brightness in a front direction of the pixel was calculated. Further, for each of Shapes 1 to 3 of the microlenses 41, a rate of improvement or a rate of decrease in brightness was calculated with reference to a brightness under the conditions of "the refractive index of the microlenses 41 being 1.6, no flattening layer 50."

Fig. 3 to Fig. 5 illustrate simulation results of Shapes 1 to 3, respectively. For example, Fig. 3 shows that at the refractive index of the flattening layer 50 of 1.1 and the refractive index of the microlenses 41 of 1.3, the brightness was improved by 11% relative to the reference brightness. Fig. 3 also shows that at the refractive index of the flattening layer 50 of 1.5 and the refractive index of the microlenses 41 of 1.3, the brightness decreased by 35% relative to the reference brightness.

While it has been demonstrated that the brightness tends to be improved relative to the reference by reducing the refractive index of the flattening layer 50 to be lower than the refractive index of the microlenses 41 irrespective of the shape, totally unexpected findings were obtained that an excessively low refractive index of the flattening layer or an excessively high refractive index of the microlenses 41 leads to a decrease in effect in improving the brightness, an optimal range of the difference in refractive index therebetween varies with the shape, and the like.

Specifically, it has been found that a value of the difference in refractive index at which the brightness improvement effect is maximized tends to increase with a decrease in the height of the microlenses 41 and an increase in the curvature radius of the lens surfaces, that is, an increase in the value of r/H. In this study, an optimal difference in refractive index for Shape 1 was 0.3, whereas optimal differences in refractive index for Shapes 2 and 3, which were 0.4 and 0.5, respectively, changed in parallel with the values of r/H. It has also been found that a substantially favorable brightness improvement effect is obtained as long as the difference in refractive index falls within a range of ±0.1 relative to the above-described optimal difference in refractive index irrespective of the shape.

For the display unit, dimensions of the microlenses 41 are variously changed in accordance with a pixel dimension or the like. Accordingly, the inventor has tried standardizing conditions that provide a favorable brightness improvement effect on the basis of the above-described findings. As a result, it has been discovered that a favorable brightness improvement effect is obtained in a case where an inequality expression (1) below is satisfied.

$$0.3 < (n_m - n_t) - 0.1(r/H)^2 + 0.2(r/H) < 0.6 \dots (1)$$

In the expression (1), $n_m$ denotes the refractive index of the microlenses 41 and nt denotes the refractive index of the flattening layer 50.

In this study, for Shape 1 with r/H in a range of 1 or greater and less than 2, a preferred range of the difference in refractive index was 0.2 or greater and 0.5 or less, and more preferably 0.2 or greater and 0.4 or less. For Shape 2 with r/H in a range of 2 or greater and less than 3, a preferred range of the difference in refractive index was 0.3 or greater and 0.6 or less, and more preferably 0.3 or greater and 0.5 or less. For Shape 3 with r/H in a range of 3 or greater, a preferred range of the difference in refractive index was 0.3 or greater, and more preferably 0.6 or greater and 0.8 or less. The respective conditions for the shapes all satisfy the expression (1) above.

In the display unit 1 according to the present embodiment, the refractive indexes of the microlenses 41 and the flattening layer 50 and the shape of the microlenses 41 are set so as to satisfy the expression (1) above on the basis of the above-described findings, which makes it possible to reduce a loss of outputted light even from light sources that are not so high in directionality, such as the organic EL devices 11, to improve the usage efficiency. As a result, it is possible to efficiently guide light generated from the organic EL devices 11 to the front of the unit irrespective of the pixel dimension or the like to significantly improve display quality such as brightness.

In the foregoing, an embodiment of the present invention is described in detail but the present invention is not limited to a specific embodiment and include alterations, combinations, and the like of the configurations within a range not departing from the scope of the present invention. Some of the alterations are described by way of example below but any other alternation is also possible. Two or more of the alterations may be combined as appropriate.

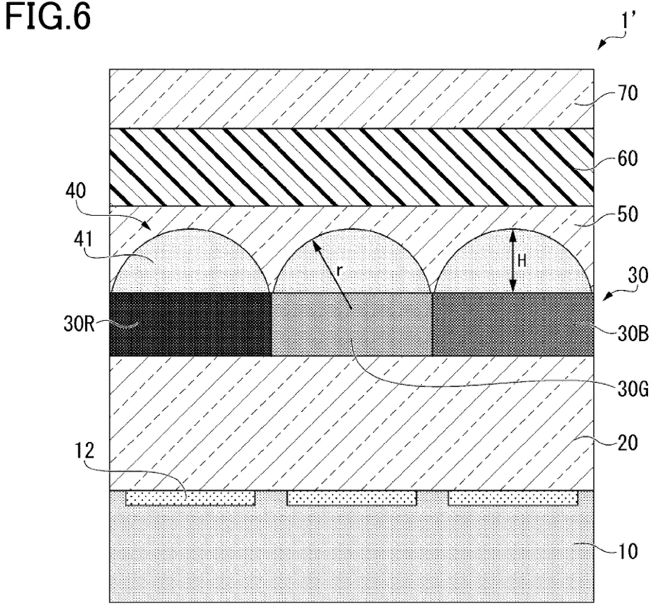

- In the display unit according to the present invention, the light sources are not limited to the above-described organic EL devices 11 and may be micro LEDs 12 illustrated in Fig. 6 or any other light source device. Fig. 6 illustrates a display unit 1' according to a modification example of an embodiment of the present invention. Fig. 6, in which the same member as that of the display unit 1 according to an embodiment of the present invention is labeled with the same reference numeral, is different from Fig. 1 merely in that the organic EL devices 11 of the display unit 1 according to an embodiment are replaced by the micro LEDs 12. Such a display unit 1' also produces an effect similar to that of the display unit 1.
- The shape of the microlenses 41 in plan view is not limited to a circular shape described in the above-described embodiment. For example, as a result of adjacent ones of the microlenses 41 being provided across the entire sub-pixel through a process such as etch-back, the microlenses 41 may have the same rectangular shape or the like as the sub-pixel in plan view.

[Industrial Applicability]

The present invention makes it possible to provide a display unit enabling a reduction in loss of outputted light of a micro LED or an organic EL device to improve usage efficiency.

[Reference Signs List]

| | |
|---|---|
| 10 | Device substrate |
| 11 | Organic EL device (light source) |
| 20 | Protective layer |
| 30 | Color filter |
| 30R | Monochromatic filter (red monochromatic filter) |
| 30G | Monochromatic filter (green monochromatic filter) |
| 30B | Monochromatic filter (blue monochromatic filter) |
| 41 | Microlens |
| 50 | Flattening layer |
| 60 | Adhesive layer |
| 70 | Translucent substrate |

**Claims**

1. A display unit comprising:

   a device substrate on which a plurality of light sources are disposed;
   a protective layer provided on the device substrate to cover the plurality of light sources;
   a color filter provided on the protective layer, the color filter including a plurality of monochromatic filters disposed corresponding to the plurality of light sources;
   a lens array provided on the color filter, the lens array including a plurality of microlenses disposed corresponding to the plurality of monochromatic filters; and
   a flattening layer provided on the lens array to cover the plurality of microlenses, the flattening layer having a refractive index lower than a refractive index of the plurality of microlenses, wherein
   the refractive index of the plurality of microlenses denoted by $n_m$, the refractive index of the flattening layer denoted by nt, and a ratio r/H between a curvature radius r and a height H of a lens surface of the plurality of microlenses satisfy the following expression (1):

   $$0.3 < (n_m - n_t) - 0.1(r/H)^2 + 0.2(r/H) < 0.6 \dots (1).$$

2. The display unit according to claim 1, wherein

   r/H is 1 or greater and less than 2, and
   a difference between $n_m$ and nt is 0.2 or greater and 0.5 or less.

3. The display unit according to claim 1, wherein

   r/H is 2 or greater and less than 3, and
   a difference between $n_m$ and nt is 0.3 or greater and 0.6 or less.

4. The display unit according to claim 1, wherein

   r/H is 3 or greater, and
   a difference between $n_m$ and nt is 0.6 or greater and 0.8 or less.

5. A display unit comprising:

   a device substrate on which a plurality of light sources are disposed;
   a protective layer provided on the device substrate to cover the plurality of light sources;
   a color filter provided on the protective layer, the color filter including a plurality of monochromatic filters disposed corresponding to the plurality of light sources;
   a lens array provided on the color filter, the lens array including a plurality of microlenses disposed corresponding to the plurality of monochromatic filters; and

a flattening layer provided on the lens array to cover the plurality of microlenses, the flattening layer having a refractive index lower than a refractive index of the plurality of microlenses, wherein

a ratio r/H between a curvature radius r and a height H of a lens surface of the plurality of microlenses is 3 or greater, and

a difference between a refractive index $n_m$ of the plurality of microlenses and a refractive index nt of the flattening layer is 0.3 or greater.

6. The display unit according to any one of claims 1 to 5, wherein
the light sources are organic EL devices or micro LEDs.

# FIG.1

1

70

60

40

50

41

H

30

30R

r

30B

30G

20

11

10

# FIG.2

# FIG.3

| SHAPE 1 (r/H1.27) | | REFRACTIVE INDEX OF FLATTENING LAYER | | | | | |
|---|---|---|---|---|---|---|---|
| | | 1.1 | 1.2 | 1.3 | 1.4 | 1.5 | NONE |
| REFRACTIVE INDEX OF MICROLENSES | 1.3 | 11% | -1% | -18% | -26% | -35% | -35% |
| | 1.4 | 12% | 12% | -1% | -17% | -26% | -26% |
| | 1.5 | 11% | 13% | 12% | 0% | -16% | -16% |
| | 1.6 | 11% | 12% | 13% | 13% | 0% | (100%) |
| | 1.7 | 8% | 12% | 13% | 14% | 13% | 13% |
| | 1.8 | 1% | 8% | 12% | 13% | 15% | 15% |

## FIG.4

| SHAPE 2 (r/H2.0) | | REFRACTIVE INDEX OF FLATTENING LAYER | | | | | |
|---|---|---|---|---|---|---|---|
| | | 1.1 | 1.2 | 1.3 | 1.4 | 1.5 | NONE |
| REFRACTIVE INDEX OF MICROLENSES | 1.3 | 12% | -1% | -13% | -21% | -27% | -27% |
| | 1.4 | 20% | 12% | -1% | -13% | -21% | -21% |
| | 1.5 | 20% | 20% | 12% | 0% | -12% | -12% |
| | 1.6 | 19% | 21% | 21% | 13% | 0% | (100%) |
| | 1.7 | 20% | 20% | 21% | 21% | 13% | 13% |
| | 1.8 | 18% | 20% | 21% | 22% | 21% | 21% |

## FIG.5

| SHAPE 3 (r/H3.17) | | REFRACTIVE INDEX OF FLATTENING LAYER | | | | | |
|---|---|---|---|---|---|---|---|
| | | 1.1 | 1.2 | 1.3 | 1.4 | 1.5 | NONE |
| REFRACTIVE INDEX OF MICROLENSES | 1.3 | 9% | -1% | -10% | -17% | -22% | -22% |
| | 1.4 | 19% | 9% | -1% | -10% | -17% | -17% |
| | 1.5 | 25% | 19% | 9% | 0% | -9% | -9% |
| | 1.6 | 25% | 25% | 19% | 10% | 0% | (100%) |
| | 1.7 | 25% | 26% | 25% | 20% | 10% | 10% |
| | 1.8 | 25% | 26% | 26% | 26% | 20% | 20% |

# FIG.6

1'

70

60

40

50

41

H

r

30

30R

30B

30G

20

12

10

| INTERNATIONAL SEARCH REPORT | International application No. |
| --- | --- |
| | **PCT/JP2023/014028** |

**A. CLASSIFICATION OF SUBJECT MATTER**

*G09F 9/30*(2006.01)i; *G02B 3/00*(2006.01)i; *G02B 5/20*(2006.01)i; *H05B 33/02*(2006.01)i; *H10K 50/00*(2023.01)i; *H10K 59/00*(2023.01)i

FI: G09F9/30 349Z; G02B3/00 A; G02B5/20 101; G09F9/30 349B; G09F9/30 365; H05B33/02; H05B33/14 A; H10K59/00

According to International Patent Classification (IPC) or to both national classification and IPC

**B. FIELDS SEARCHED**

Minimum documentation searched (classification system followed by classification symbols)

G02F1/133-1/1334; G02F1/1339-1/1341; G02F1/1347; G09F9/00-9/46; H05B33/00-33/28; H05B44/00; H05B45/60; H10K50/00-99/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2020-184481 A (SEIKO EPSON CORP) 12 November 2020 (2020-11-12) paragraphs [0043]-[0056], fig. 3 | 1-6 |
| Y | CN 110928017 A (WUHAN CHINA STAR OPTOELECTRONICS TECHNOLOGY CO., LTD.) 27 March 2020 (2020-03-27) paragraphs [0055], [0061], fig. 1, 5 | 1-6 |
| Y | KR 10-2012-0126562 A (LG DISPLAY CO., LTD.) 21 November 2012 (2012-11-21) paragraphs [0107]-[0109], fig. 6 | 1-6 |
| A | JP 2021-015732 A (CANON KK) 12 February 2021 (2021-02-12) entire text, all drawings | 1-6 |
| A | WO 2011/121668 A1 (PANASONIC CORPORATION) 06 October 2011 (2011-10-06) entire text, all drawings | 1-6 |

☑ Further documents are listed in the continuation of Box C.     ☑ See patent family annex.

| | | |
| --- | --- | --- |
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| **15 May 2023** | **30 May 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

| INTERNATIONAL SEARCH REPORT | International application No. |
|---|---|
| | **PCT/JP2023/014028** |

**C. DOCUMENTS CONSIDERED TO BE RELEVANT**

| Category* | Citation of document, with indication, where appropriate, of the relevant passages | Relevant to claim No. |
|---|---|---|
| A | WO 2021/171857 A1 (SONY SEMICONDUCTOR SOLUTIONS CORPORATION) 02 September 2021 (2021-09-02)<br>entire text, all drawings | 1-6 |
| A | WO 2021/261262 A1 (SONY SEMICONDUCTOR SOLUTIONS CORPORATION) 30 December 2021 (2021-12-30)<br>entire text, all drawings | 1-6 |
| A | US 2021/0202917 A1 (LG DISPLAY CO., LTD.) 01 July 2021 (2021-07-01)<br>entire text, all drawings | 1-6 |

Form PCT/ISA/210 (second sheet) (January 2015)

**INTERNATIONAL SEARCH REPORT**
Information on patent family members

| International application No. |
| --- |
| **PCT/JP2023/014028** |

| Patent document cited in search report | | | Publication date (day/month/year) | Patent family member(s) | | | Publication date (day/month/year) |
| --- | --- | --- | --- | --- | --- | --- | --- |
| JP | 2020-184481 | A | 12 November 2020 | US | 2020-0358036 | A1 | |
| | | | | paragraphs [0070]-[0083], fig. 3 | | | |
| CN | 110928017 | A | 27 March 2020 | (Family: none) | | | |
| KR | 10-2012-0126562 | A | 21 November 2012 | (Family: none) | | | |
| JP | 2021-015732 | A | 12 February 2021 | US | 2021-0013453 | A1 | |
| | | | | entire text, all drawings | | | |
| | | | | EP | 003764399 | A1 | |
| | | | | CN | 112216730 | A | |
| WO | 2011/121668 | A1 | 06 October 2011 | US | 2012-0217521 | A1 | |
| | | | | entire text, all drawings | | | |
| | | | | CN | 102293053 | A | |
| | | | | KR | 10-2013-0006728 | A | |
| WO | 2021/171857 | A1 | 02 September 2021 | EP | 004092454 | A1 | |
| | | | | entire text, all drawings | | | |
| | | | | CN | 115066979 | A | |
| | | | | KR | 10-2022-0146436 | A | |
| WO | 2021/261262 | A1 | 30 December 2021 | (Family: none) | | | |
| US | 2021/0202917 | A1 | 01 July 2021 | KR | 10- 2262677 | B1 | |
| | | | | entire text, all drawings | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022065160 A
- JP 2021136208 A
- JP 2020184481 A